# EUROPÄISCHE PATENTSCHRIFT

(11) **EP 2 880 199 B1**
(45) Veröffentlichungstag und Bekanntmachung des Hinweises auf die Patenterteilung: **20.02.2019**
(21) Anmeldenummer: 13745008.6
(22) Anmeldetag: 23.07.2013
(51) Int. Cl.: C23C 28/04, C23C 28/00, C23C 30/00, C23C 14/06, C23C 14/34

(54) **TIALN-BESCHICHTETES WERKZEUG**
TIALN-COATED TOOL
OUTIL REVÊTU DE TIALN

(30) Priorität: 03.08.2012 DE 102012107129
(43) Veröffentlichungstag der Anmeldung: 10.06.2015
(73) Patentinhaber: Walter AG, 72072 Tübingen (DE)
(72) Erfinder: SCHIER, Veit, 70771 Leinfelden-Echterdingen (DE); ALBERS, Ulrich, 72181 Starzach - Börstingen (DE)
(74) Vertreter: WSL Patentanwälte Partnerschaft mbB
(86) Internationale Anmeldenummer: PCT/EP2013/065550
(87) Internationale Veröffentlichungsnummer: WO 2014/019897

(56) Entgegenhaltungen:
- EP-A2- 1 038 989
- CA-A1- 2 600 097
- JP-A- H0 797 679
- JP-A- H1 161 380
- US-A1- 2005 129 986
- US-A1- 2005 170 162
- US-A1- 2010 190 032
- US-A1- 2011 081 539

## Beschreibung

### Gegenstand der Erfindung

Die Erfindung betrifft ein Werkzeug mit einem Grundkörper aus Hartmetall, Cermet, Keramik, Stahl oder Schnellarbeitsstahl und einer darauf im PVD-Verfahren aufgebrachten ein- oder mehrschichtigen Verschleißschutzbeschichtung, wobei wenigstens eine Schicht der Verschleißschutzbeschichtung eine Titan-Aluminium-Nitrid-Schicht, TiₓAl_{y}N mit x + y = 1 ist.

### Hintergrund der Erfindung

Schneidwerkzeuge, insbesondere Werkzeuge für die spanende Metallbearbeitung, bestehen aus einem Grundkörper, der beispielsweise aus Hartmetall, Cermet, Keramik, Stahl oder Schnellarbeitsstahl hergestellt ist. Zu Erhöhung der Standzeiten oder auch zu Verbesserung der Schneideigenschaften wird auf den Grundkörper häufig mittels CVD- oder PVD-Verfahren eine ein- oder mehrschichtige Verschleißschutzbeschichtung aus Hartstoffen aufgebracht. Bei den PVD-Verfahren unterscheidet man zwischen verschiedenen Verfahrensvarianten, wie Magnetronsputtern, Lichtbogenverdampfen (Arc-PVD), Ionenplattierung, Elektronenstrahlverdampfung und Laserablation. Magnetronsputtern und Lichtbogenverdampfen zählen zu den am häufigsten für die Beschichtung von Werkzeugen angewendeten PVD-Verfahren. Innerhalb einzelner PVD-Verfahrensvarianten gibt es wiederum unterschiedliche Modifikationen, wie beispielweise ungepulstes oder gepulstes Magnetronsputtern oder ungepulstes oder gepulstes Lichtbogenverdampfen usw.

Das Target im PVD-Verfahren kann aus einem reinen Metall oder einer Kombination von zwei oder mehr Metallen bestehen. Umfasst das Target mehrere Metalle, so werden alle diese Metalle gleichzeitig in die in dem PVD-Verfahren aufgebaute Lage einer Beschichtung eingebaut. Das Mengenverhältnis der Metalle zueinander in der aufgebauten Lage wird von dem Mengenverhältnis der Metalle in dem Target abhängen, aber auch von den Bedingungen in dem PVD-Verfahren, da einzelne Metalle unter bestimmten Bedingungen in höheren Mengen aus dem Target herausgelöst werden und/oder sich in höheren Mengen auf dem Substrat abscheiden als andere Metalle.

Zur Erzeugung bestimmter Metallverbindungen werden dem Reaktionsraum des PVD-Verfahrens reaktive Gase zugeführt, wie z.B. Stickstoff zur Erzeugung von Nitriden, Sauerstoff zur Erzeugung von Oxiden, kohlenstoffhaltige Verbindungen zur Erzeugung von Carbiden oder Gemische dieser Gase zur Erzeugung von entsprechenden Mischverbindungen, wie Carbonitriden, Oxicarbiden etc.

Die WO 96/23911 A1 beschreibt eine Verschleißschutzschicht auf einem Substrat, bestehend aus einer unmittelbar auf dem Substrat aufgebrachten Hartstofflage und darüber einer Abfolge von 10 bis 1000 weiteren Einzellagen, die abwechselnd aus einem metallischen Hartstoff und einem kovalenten Hartstoff mit einer Dicke der Einzellagen zwischen 1 und 30 nm bestehen. Durch die periodisch alternierende Anordnung von Einzellagen aus metallischen Hartstoffen und kovalenten Hartstoffen sollen die mechanischen und chemischen Eigenschaften der Verschleißschutzschicht verbessert werden.

Die WO 2006/041367 A1 beschreibt ein beschichtetes Schneidwerkzeug aus einem Hartmetallsubstrat und einer im PVD-Verfahren abgeschiedenen Beschichtung, die wenigstens eine Lage aus TiAlN mit einer Dicke von 1,5 bis 5 µm und einer Druckeigenspannung > 4 bis 6 GPa umfasst. Die TiAlN-Lage soll gegenüber bekannten Lagen eine verbesserte Haftung auf dem Untergrund aufweisen.

Die EP 2 298 954 A1 beschreibt ein Verfahren zur Herstellung eines beschichteten Schneidwerkzeugs, bei dem auf einem Substrat mittels PVD-Verfahren eine Hartstoffbeschichtung aufgebracht wird, beispielsweise TiAlN, TiAlCrN oder TiAlCrSiN, wobei während des Abscheidungsverfahrens die Bias-Spannung des Substrates variiert wird. Durch das Verfahren soll eine verbesserte Verschleißbeständigkeit und höhere Lebensdauer des Werkzeugs erzielt werden.

US 2005/129986 offenbart ein Werkzeug mit einem Grundkörper aus Cermet und einer darauf im PVD-Verfahren aufgebrachten mehrschichtigen Verschleißschutzbeschichtung.

Für bestimmte Metallbearbeitungsvorgänge, wie z.B. das Fräsen und Drehen, werden besonders hohe Anforderungen an das Werkzeug gestellt. Wichtige Parameter für solche Werkzeuge sind eine hohe Härte, ein hoher Elastizitätsmodul (E-Modul, Youngscher Modul) und eine niedrige Oberflächenrauheit. Bekannte Schneidwerkzeuge für die beschriebenen Anwendungen weisen eine im PVD-Verfahren aufgebrachte TiAlN-Beschichtung auf, die typischerweise einen Elastizitätsmodul unter 400 GPa und eine Vickers-Härte bis zu 3500 HV besitzt. Werden solche TiAlN-Schichten im Lichtbogenverfahren abgeschieden, neigen sie aufgrund der niedrigen Schmelztemperatur des Aluminiums zur Bildung von sogenannten Droplets auf und in der Schicht, was sich nachteilig auf die Leistung der Beschichtung auswirkt. Durch entsprechende Wahl der Parameter des Abscheidungsverfahrens lassen sich die Härte und der Elastizitätsmodul im PVD-Verfahren steigern, jedoch führt dies in der Regel zu hohen Druckeigenspannungen in der Schicht in Größenordnungen > 3 GPa, die sich nachteilig auf die Stabilität der Schneidkante auswirken. Unter hoher Belastung neigt die Schneidkante zu frühem Abplatzen und damit zu einem schnellen Verschleiß des Werkzeugs.

### Aufgabe

Die Aufgabe der vorliegenden Erfindung bestand darin, ein Werkzeug bereitzustellen mit einer gegenüber dem Stand der Technik verbesserten Beschichtung mit hoher Härte, hohem Elastizitätsmodul und gleichzeitig akzeptablen Eigenspannungen und einer verbesserten Stabilität der Schneidkante.

### Beschreibung der Erfindung

Gelöst wird diese Aufgabe durch ein Werkzeug mit dem Gegenstand von Anspruch 1.

Es hat sich überraschen gezeigt, dass eine TiAlN-Schicht der erfindungsgemäßen Art, mit sich periodisch abwechselnden TiAlN-Lagen mit unterschiedlichen Konzentrationsverhältnissen von Ti zu Al gegenüber herkömmlichen TiAlN-Lagen ohne wechselnde Konzentrationsverhältnisse eine höhere Härte und einen höheren Elastizitätsmodul aufweisen, ohne dass gleichzeitig die Druckeigenspannung in der Schicht stark ansteigt, wie dies in bekannten TiAlN-Schichten nach dem Stand der Technik beobachtet wird.

Die Al-Konzentration y(B) in den Lagen (B) beträgt höchstens 70 At.-%. Da die Al-Konzentration y(B) in den Lagen (B) 10 bis 25 At.-% höher ist als die Al-Konzentration y(A) in den Lagen (A), liegt die Al-Konzentration in der gesamten Titan-Aluminium-Nitrid-Schicht, TiₓAl_{y}N, unter 70 At.-%. Bei einer zu hohen Al-Konzentration kommt es mit Nachteil zur Ausbildung von vergleichsweise weichen Phasen.

Ohne dass die Erfinder sich hiermit an eine Theorie binden wollen, wird angenommen, dass der höhere Aluminiumanteil in den Lagen (B) gegenüber den Lagen (A) aufgrund der gegenüber Titan geringeren Größe des Aluminiums zu kleineren Gitterkonstanten in dem kubisch flächenzentrierten Gitter und damit zu einer entsprechenden Variation der Eigenspannungsverhältnisse führt, die sich in einer niedrigeren Druckeigenspannung als bei herkömmlichen TiAIN-Lagen zeigt, welche ohne wechselnde Konzentrationsverhältnisse abgeschieden werden. Die erfindungsgemäßen Werkzeuge zeichnen sich durch eine höhere Verschleißbeständigkeit und längere Standzeiten aus, insbesondere durch weniger Abplatzen der Beschichtung an der Schneidkante.

Der vorteilhafte Effekt der erfindungsgemäßen Lagenstruktur der TiAlN-Schicht zeigt sich bereits bei Anwendung weniger sich periodisch abwechselnder Ti_{x(A)}Al_{y(A)}N-Lagen (A) und Ti_{x(B)}Al_{y(B)}N-Lagen (B) mit unterschiedlichen Konzentrationsverhältnissen von Ti zu Al gemäß der Erfindung.

Die Erfindung weist die wenigstens eine TiₓAl_{y}N-Schicht in der Verschleißschutzbeschichtung wenigstens 40 sich periodisch abwechselnde TiAlN-Lagen (A) und TiAlN-Lagen (B) auf. Die gesamte TiAlN-Schicht umfasst bei dieser Ausführungsform somit wenigstens 40 TiAlN-Lagen (A) und wenigstens 40 TiAlN-Lagen (B), d.h. insgesamt wenigstens 80 TiAlN-Lagen. Die Anwendung von weniger als 40 sich periodisch abwechselnder TiAlN-Lagen (A) und (B) hat den Nachteil, dass die erfindungsgemäß gegenüber dem Stand der Technik höhere Härte und der höhere E-Modul nicht erzielt werden.

Ohne dass die Erfindung an die nachfolgende Theorie gebunden ist, wird angenommen, dass die Vorteile der Erfindung unter anderem darauf beruhen, dass sich entlang der Lagenwechsel an den Grenzflächen zwischen TiAlN-Lagen (A) und (B) lokal sehr begrenzte hohe Eigenspannungen aufbauen, die aber nach Außen nicht messbar sind und keinen Einfluss auf die Haftung der Beschichtung auf dem Substrat haben. Ist die Anzahl der sich periodisch abwechselnden Ti_{x(A)}Al_{y(A)}N-Lagen (A) und Ti_{x(B)}Al_{y(B)}N-Lagen (B) zu gering, kann sich der durch die Lagenwechsel erzielbare Effekt nicht ausprägen.

In einer weiteren bevorzugten Ausführungsform der Erfindung weist die wenigstens eine TiₓAl_{y}N-Schicht in der Verschleißschutzbeschichtung höchstens 300 sich periodisch abwechselnde TiAlN-Lagen (A) und TiAlN-Lagen (B) auf. Die gesamte TiAlN-Schicht umfasst bei dieser Ausführungsform somit höchstens 300 TiAlN-Lagen (A) und höchstens 300 TiAlN-Lagen (B), d.h. insgesamt höchstens 600 TiAlN-Lagen. Mehr als 300 sich periodisch abwechselnde TiAlN-Lagen (A) und (B) haben den Nachteil, dass sie produktionstechnisch nur mit sehr hohem Aufwand und damit verbundenen hohen Kosten herstellbar sind.

In der Erfindung weisen die Ti_{x(A)}Al_{y(A)}N-Lagen (A) eine Dicke im Bereich von 2 bis 40 nm, vorzugsweise 4 bis 15 nm, und die Ti_{x(B)}Al_{y(B)}N-Lagen (B) eine Dicke im Bereich von 1 bis 20 nm, vorzugsweise 2 bis 7 nm, auf. Zweckmäßigerweise weisen die TiAlN-Lagen (A) die 1,5- bis 3,0-fache Dicke, vorzugsweise etwa die 2-fache Dicke der TiAlN-Lagen (B) auf. Auf eine dickere TiAlN-Lage (A) folgt somit eine dünnere TiAlN-Lage (B) mit erhöhtem Aluminiumgehalt.

Ohne dass die Erfindung an die nachfolgende Theorie gebunden ist, wird angenommen, dass die Vorteile der Erfindung unter anderem darauf beruhen, dass die dickeren Ti_{x(A)}Al_{y(A)}N-Lagen (A) eine Phasenstabilisierung in den dünneren Ti_{x(B)}Al_{y(B)}N-Lagen (B) bewirken. Bei den Al-reicheren Ti_{x(B)}Al_{y(B)}N-Lagen (B) besteht das Risiko, dass neben kubischem TiAlN hexagonales AlN entsteht, welches eine erheblich geringere Härte und Festigkeit besitzt. Bleiben diese Lagen dünn, wie im oben genannten bevorzugten Bereich, so stabilisieren die angrenzenden Ti-reicheren dickeren Ti_{x(A)}Al_{y(A)}N-Lagen (A) die kubische TiAlN-Phase in den Al-reicheren dünneren Ti_{x(B)}Al_{y(B)}N-Lagen (B).

Die sich periodisch abwechselnder Ti_{x(A)}Al_{y(A)}N-Lagen (A) und Ti_{x(B)}Al_{y(B)}N-Lagen (B) mit unterschiedlichen Konzentrationsverhältnissen von Ti zu Al gemäß der Erfindung lassen sich trotz ihrer geringen Dicke im Transmissionselektrodenmikroskop (TEM) nachweisen. Dem Fachmann auf dem Gebiet ist die Technik hinlänglich bekannt.

In einer weiteren bevorzugten Ausführungsform der Erfindung beträgt das Konzentrationsverhältnis von Ti zu Al in den Ti_{x(A)}Al_{y(A)}N-Lagen (A) x(A):y(A) = 0,40 : 0,60 bis 0,60 : 0,40. Weiter bevorzugt beträgt das Konzentrationsverhältnis x(A) : y(A) = 0,45 : 0,55 bis 0,55 : 0,45, besonders bevorzugt x(A) : y(A) etwa 0,50 : 0,50. Ist der Al-Anteil in den Ti_{x(A)}Al_{y(A)}N-Lagen (A) zu gering, wirkt sich dies nachteilig auf die Temperaturbeständigkeit der Beschichtung und somit auf die Haltbarkeit des Werkzeugs beispielsweise bei der Metallbearbeitung unter hoher Temperaturbelastung oder Temperaturwechselbelastung aus. Ist der Al-Anteil in den Ti_{x(A)}Al_{y(A)}N-Lagen (A) jedoch zu hoch, wirkt sich dies nachteilig auf die Härte und den E-Modul der Beschichtung aus.

Die Abscheidung der erfindungsgemäßen TiAlN-Schicht erfolgt in einem oder mehreren der hierin nachfolgend genannten PVD-Verfahren. Die Variation der Aluminiumkonzentration in der abgeschiedenen Lage kann vorteilhaft dadurch erreicht werden, dass in der PVD-Anlage unterschiedliche TiAl-Mischtargets angeordnet sind mit unterschiedlichen Konzentrationsverhältnissen von Ti zu Al und das Substrat periodisch an den unterschiedlichen Mischtargets vorbeigeführt wird. Die Abscheidung von entsprechenden TiAl-Mischtargets erfolgt vorzugsweise durch Lichtbogenverdampfen, Magnetron-, dualem Magnetron- oder HIPIMS-Verfahren. Geeignete Mischtargets enthalten beispielsweise Ti und Al im Verhältnis 50 : 50 für die Lagen (A) und beispielsweise Ti und Al im Verhältnis 33 : 67 für die Lagen (B). Andere Konzentrationsverhältnisse in den Mischtargets sind selbstverständlich ebenfalls möglich, um andere Konzentrationsverhältnisse von Ti und Al in den abgeschiedenen Lagen zu erhalten. Anstelle des Mischtargets mit erhöhtem Aluminiumgehalt, können alternativ auch reine Aluminiumtargets oder Targets mit hohem Aluminiumgehalt im Magnetron-, dualen Magnetron- oder HIPIMS-Verfahren eingesetzt werden. Für reine Aluminiumtargets oder Targets mit hohem Aluminiumgehalt ist Lichtbogenverdampfen weniger geeignet, da bei diesem PVD-Verfahren die Gefahr der Dropletbildung aufgrund des niedrigen Schmelzpunktes des Aluminiums hoch ist.

In einer bevorzugten Ausführungsform des erfindungsgemäßen Werkzeugs ist die TiAlN-Schicht mit mehrlagiger Unterstruktur die äußerste Schicht der Verschleißschutzbeschichtung, welche bei der Metallbearbeitung mit dem Werkstück in Kontakt kommt. Alternativ können über der TiAlN-Schicht weitere Hartstoffschichten vorgesehen sein.

In einer weiteren alternativen Ausführungsform ist über der TiAlN-Schicht wenigstens bereichsweise eine dünne Verschleißerkennungsschicht, vorzugsweise eine TiN- oder CrN-Schicht mit einer Dicke von 0,1 bis 1,5 µm vorgesehen. Verschleißerkennungsschichten der vorgenannten Art sind an sich bekannt und dienen in erster Linie als Dekorschichten und/oder dazu anzuzeigen, ob und in welchem Umfang das Werkzeug bereits benutzt wurde und wie stark der im Laufe der Benutzung aufgetretene Verschleiß ist. Die dünne Verschleißerkennungsschicht wird bei der Benutzung des Werkzeugs erkennbar abgenutzt, und bei stärkerer Abnutzung wird die darunter liegende, meist andersfarbige Verschleißschutzschicht sichtbar.

In der erfindungsgemäßen Ausführungsform des Werkzeugs weist die TiAlN-Schicht eine Vickers-Härte Hv von 2500 bis 4000 HV 0,015 auf, vorzugsweise von 3000 bis 3500 HV 0,015. Die hohe Härte der erfindungsgemäßen TiAlN-Schicht hat besondere Vorteile bei der Metallbearbeitung, insbesondere beim Drehen und Fräsen, da diese unter den trennenden Verfahren mit geometrisch bestimmter Schneide diejenigen mit den höchsten Ansprüchen an den Schneidstoff hinsichtlich Härte, Zähigkeit, Verschleißfestigkeit und Temperaturbeständigkeit sind. Eine zu niedrige Härte hat den Nachteil, dass die Verschleißfestigkeit der Beschichtung abnimmt. Eine zu hohe Härte hat den Nachteil, dass die Zähigkeit der Beschichtung abnimmt und die Beschichtung spröde wird.

In der erfindungsgemäßen Ausführungsform des Werkzeugs weist die TiAlN-Schicht einen Elastizitätsmodul von 380 GPa bis 470 GPa, bevorzugt von 420 GPa bis 460 GPa auf. Bei äußerer Beanspruchung des Werkzeugs beim Zerspanvorgang werden in der Schicht und im Substrat mechanische Spannungen erzeugt, deren Höhe über den Elastizitätsmodul mit der eingebrachten elastischen Verformung verknüpft ist. Ist der Elastizitätsmodul der Schicht zu gering, entstehen innerhalb der Schicht geringe Spannungen bei mechanischer Verformung des Werkzeugs im Gebrauch, was mit dem Nachteil verbunden ist, dass die Schicht auch nur einen geringen Teil der Zerspankräfte aufnehmen kann. Ist der Elastizitätsmodul jedoch zu hoch, hat dies den Nachteil, dass bei mechanischer Verformung zu hohe Kräfte über die Schicht abgeleitet werden, wodurch sie vorzeitig zerstört werden kann.

Wie bereits ausgeführt wurde, ist für bestimmte Metallbearbeitungsanwendungen, insbesondere Drehen und Fräsen, ganz besonders bei Metallbearbeitungsanwendungen mit unterbrochenem Schnitt, die Kombination aus hoher Härte und hohem Elastizitätsmodul besonders vorteilhaft. Die hohe Härte sorgt für hohe Verschleißbeständigkeit. Eine hohe Härte geht jedoch üblicherweise mit einer erhöhten Brüchigkeit einher. Der hohe Elastizitätsmodul sorgt gleichzeitig dafür, dass das Material eine geringere Brüchigkeit aufweist und beispielsweise beim unterbrochenen Schnitt auftretende starke mechanische Wechselbelastungen besser kompensieren kann. Durch die erfindungsgemäße TiAlN-Schicht erhält die Verschleißschutzbeschichtung des Werkzeug diese vorteilhaften Eigenschaften.

Härte und E-Modul (genauer der sogenannte reduzierte E-Modul) werden mittels Nanoindentierung gemessen. Hierbei wird ein Diamant-Prüfkörper nach Vickers in die Schicht gedrückt und während der Messung die Kraft-Weg-Kurve aufgezeichnet. Aus dieser Kurve können dann die mechanischen Kennwerte des Prüflings berechnet werden, unter anderem Härte und (reduzierter) E-Modul. Für die Bestimmungen der Härte und des E-Moduls der erfindungsgemäßen Schicht wurde ein Fischerscope® H100 XYp der Firma Helmut Fischer GmbH, Sindelfingen, Deutschland, verwendet. Zu beachten ist, dass die Eindrucktiefe nicht mehr als 10% der Schichtdicke betragen sollte, da ansonsten Eigenschaften des Substrates die Messungen verfälschen können.

Die Eigenspannungen in der erfindungsgemäßen Schicht lassen sich durch Röntgendiffraktion überprüfen. Dabei lassen sich Eigenspannungen erster, zweiter und dritter Ordnung unterscheiden, die sich in ihrer Reichweite und damit in ihrer Auswirkung auf die Schichthaftung unterscheiden. Für die Haftung der Schicht auf dem Werkzeug hat es sich als vorteilhaft erwiesen, wenn in der Schicht die Eigenspannungen erster und zweiter Ordnung nicht zu hoch werden, zweckmäßigerweise nicht höher als - 5 GPa (Druckspannung).

In der erfindungsgemäßen Ausführungsform des Werkzeugs weist die TiAlN-Schicht eine mittlere Oberflächenrauheit Ra, gemessen über eine Länge von 10 µm, von ≤ 1,0 µm, vorzugsweise ≤ 0,5 µm auf. Durch geeignete Wahl der Abscheideparameter im PVD-Verfahren kann eine deutliche Reduzierung der Droplethäufigkeit der abgeschiedenen TiAlN-Lagen erzielt werden, wodurch bereits die abgeschiedene Schicht eine niedrige mittlere Oberflächenrauheit Ra erhält. Daher genügt ein deutlich reduzierter Aufwand beim anschließenden Glätten der Oberflächen nach dem Beschichten, um einen für die Zerspanung optimalen Zustand zu erzielen. Zur Glättung der Oberfläche des Werkzeugs nach dem Abscheiden der Schichten eignen sich bekannte Strahlverfahren, Schleifen oder Bürsten mit entsprechend harten und feinen Materialien.

Ein zur Glättung der Oberfläche des Werkzeugs geeignetes Verfahren ist beispielsweise Nassstrahlen mit Glasperlen bei einem Druck von etwa 2,5 bar mit einem Strahlmedium aus 50% Glasperlen mit einem Durchmesser von 70-110 µm und 50% Glasperlen mit einem Durchmesser von 40-70 µm. Die geeignete Strahlbehandlungsdauer ist durch Prüfung der gewünschten Oberflächenglätte zu ermitteln. Die Bearbeitungszeit bei einem Vollhartmetallfräser mit einem Durchmesser von 10 mm liegt beispielsweise bei etwa 10 Sekunden.

Ein weiteres geeignetes Verfahren zur Glättung der Oberfläche des Werkzeugs ist Schleppschleifen. Ein geeignetes Schleifmittel ist beispielsweise ein Kokosnussschalengranulat mit feinem Diamantpulver als Schleifmittel und Haftöl.

Auch das Nassstrahlen mit Korund mit beispielsweise der Körnung 280/320 und einer Strahlmittelkonzentration in der Flüssigkeit von etwa 18% ist insbesondere für eine Nachbehandlung geeignet. Hierbei wird zweckmäßigerweise ein Strahldruck von etwa 1,5 bis 2 bar angewendet, wobei Strahlrichtung und Strahlwinkel in Abhängigkeit vom Werkzeugtyp und der Werkzeuggröße einzustellen sind.

Die Oberflächenrauheit wurde an polierten Test-Wendeschneidplatten mit einem Messgerät Hommel-ETAMIC TURBO WAVE V7.32 der Firma HOMMEL-ETAMIC GmbH, Schwenningen, Deutschland, gemessen (Taster: TKU300 - 96625_TKU300/TS1; Messbereich: 80µm; Teststrecke: 4,8mm; Geschwindigkeit: 0,5mm/s).

In einer weiteren bevorzugten Ausführungsform der Erfindung weist das Werkzeug eine verrundete Schneidkante mit einem Kantenradius im Bereich von 3 bis 10 µm, vorzugsweise von 5 bis 7 µm auf. Bei zu geringem Schneidkantenradius besteht die Gefahr, dass die Kante schnell abbricht. Ein zu hoher Schneidkantenradius hat sehr hohe Schnittkräfte zur Folge, die sich ungünstig auf die Lebensdauer des Werkzeugs und die Spanformen auswirken.

Das erfindungsgemäße Werkzeug kann als beschichtetes Vollhartmetallwerkzeug oder als beschichtete Wendeschneidplatte ausgebildet sein.

Weitere Vorteile, Merkmale und Ausführungsformen der vorliegenden Erfindung werden anhand der nachfolgenden Beispiele weiter erläutert.

### Beispiele

### Beispiel 1 - Schaftwerkzeuge

In diesem Beispiel wurden Vollhartmetall (VHM)-Schaftfräser (sog. "Tough Guy") mit einer erfindungsgemäßen Beschichtung und einer Vergleichsbeschichtung nach dem Stand der Technik versehen und in die Beschichteten Werkzeuge in Zerspanversuchen verglichen.

### Spezifikation des Vollhartmetall (VHM)-Schaftfräsers

| | |
|---|---|
| Durchmesser: | 10 mm, |
| Schneidenanzahl: | 4 |
| Schneidenlänge: | 200 % des Durchmessers |
| Spiralwinkel der Spannuten: | 50° |
| Spanwinkel an der Querschneide: | 13,5° |
| Spanwinkel an der Hauptschneide: | 10,5° |
| Substratmaterial: | Feinkorn-Hartmetall mit einer mittleren WC-Korngröße von 0,8 µm und einem Bindergehalt von 10 Gew.-% Co |

Das Substrat wurde vor dem Beschichten zunächst durch Nassstrahlen mit Glasperlen einer Schneidkantenverrundung bis zu einem Radius von 7 µm unterzogen.

### Herstellung einer erfindungsgemäßen Beschichtung

Auf der Substratoberfläche wurde zunächst eine 0,2 µm dicke TiAlN-Zwischenlage durch Lichtbogenverdampfen von einem Ti-Al-Mischtarget (Ti:Al = 50:50) abgeschieden (Bias: 100 V, 4 Pa Stickstoff, 0,8 A/cm² spezifischer Verdampferstrom, Abscheidetemperatur: 550 °C). Darüber wurde ebenfalls durch Lichtbogenverdampfen eine erfindungsgemäße Verschleißschutzbeschichtung mit einer Gesamtschichtdicke von 2 µm abgeschieden. Die Abscheidung erfolgte simultan von 4 Ti-Al-Mischtargets mit einem Verhältnis Ti:Al = 50:50 und 2 Ti-Al-Mischtargets mit einem Verhältnis Ti:Al = 33:67. (Bias: 60 V, 4,5 Pa Stickstoff, 0,8 A/cm² spezifischer Verdampferstrom bei beiden Targetsorten, Abscheidetemperatur: 550 °C). Das Substrat wurde auf einem Drehteller an den verschiedenen Targetsorten vorbeigeführt. Insgesamt wurden periodisch abwechselnd 90 Ti_{x(A)}Al_{y(A)}N-Lagen (A) mit Ti:Al = 50:50 und 90 Ti_{x(B)}Al_{y(B)}N-Lagen (B) mit Ti:Al = 33:67 abgeschieden, wobei die Ti_{x(A)}Al_{y(A)}N-Lagen (A) jeweils eine Dicke von etwa 15-19 nm und die Ti_{x(B)}Al_{y(B)}N-Lagen (B) jeweils eine Dicke von etwa 3-6 nm hatten. Anschließend wurde ebenfalls durch Lichtbogenverdampfen eine abschließende äußerste Lage von einem Ti-Al-Mischtarget mit einem Verhältnis Ti:Al = 33:67 mit einer Schichtdicke von 0,1 µm abgeschieden. (Bias: 40 V, 3,0 Pa Stickstoff, 0,8 A/cm² spezifischer Verdampferstrom, Abscheidetemperatur: 550 °C).

### Herstellung einer Vergleichsbeschichtung

Auf der Substratoberfläche wurde eine einlagige TiAlN-Verschleißschutzbeschichtung mit einer Gesamtschichtdicke von 2,5 µm von Ti-Al-Mischtargets mit einem Verhältnis Ti:Al = 33:67 durch Lichtbogenverdampfen abgeschieden (Bias: 80 V, 1,5 Pa Stickstoff, Abscheidetemperatur: 550 °C, 2 A/cm² spezifischer Verdampferstrom).

### Zerspanversuche 1

Die beschichteten Werkzeuge wurden in Fräsversuchen verglichen und der durchschnittliche Freiflächenverschleiß V_{b} sowie der maximale Freiflächenverschleiß V_{bmax} als Mittelwert aus je zwei Versuchen ermittelt. Die Ergebnisse der Versuche sind in der nachfolgenden Tabelle 1 angegeben.

| | |
|---|---|
| Werkstück: | 42CrMo4-Stahl Nr, 1.7225, vergütet auf ca. 850 N/mm² |
| Zerspanbedingungen: | Zahnvorschub f_{Z} = 0,07 mm |
| | Schnittgeschwindigkeit v_{c} = 170 m/min |
| | Schnittbreite aₑ = 4 mm |
| | Schnitttiefe aₚ = 8 mm |
| | Kühlung mit KSS 5% |
| | (= Kühlschmierstoff Wasser-in-Öl-Emulsion mit 5% Öl) |

Die Bearbeitung wurde bei einem durchschnittlichen Freiflächenverschleiß von V_{b} > 0,2 mm oder einem maximalen Freiflächenverschleiß V_{bmax} > 0,25 mm abgebrochen und in den Ergebnissen dann mit (./.) gekennzeichnet.

**Tabelle 1**

| **Standweg / m** | **75** | **150** | **225** | **300** | **375** |
|---|---|---|---|---|---|
| V_{b} / mm Erfindung | 0,06 | 0,07 | 0,07 | 0,08 | 0,10 |
| V_{b}max / mm Erfindung | 0,08 | 0,13 | 0,15 | 0,21 | 0,21 |
| V_{b} / mm Vergleich | 0,08 | 0,08 | 0,08 | ./. | ./. |
| V_{b}max / mm Vergleich | 0,15 | 0,15 | 0,20 | ./. | ./. |

### Beispiel 2 - Schaftwerkzeuge

In diesem Beispiel wurden Vollhartmetall (VHM)-Schaftfräser (sog. "Tough Guy") exakt wie in Beispiel 1 mit einer erfindungsgemäßen Beschichtung und einer Vergleichsbeschichtung nach dem Stand der Technik versehen und in die Beschichteten Werkzeuge in Zerspanversuchen verglichen. Lediglich der beschichtete Schaftfräser hatte eine gegenüber Beispiel 1 abweichende Geometrie.

Das Substrat wurde vor dem Beschichten ebenfalls zunächst durch Nassstrahlen mit Glasperlen einer Schneidkantenverrundung bis zu einem Radius von 7 µm unterzogen.

### Spezifikation des Vollhartmetall (VHM)-Schaftfräsers

| | |
|---|---|
| Durchmesser: | 3 mm, |
| Schneidenanzahl: | 3 |
| Schneidenlänge: | 200 % des Durchmessers |
| Spiralwinkel der Spannuten: | 50° |
| Spanwinkel an der Querschneide: | 13,5° |
| Spanwinkel an der Hauptschneide: | 10,5° |
| Substratmaterial: | Feinkorn-Hartmetall mit einer mittleren WC-Korngröße von 0,8 µm und einem Bindergehalt von 10 Gew.-% Co |

### Zerspanversuche 2

Die beschichteten Werkzeuge wurden in Fräsversuchen verglichen und der durchschnittliche Freiflächenverschleiß V_{b} sowie der maximale Freiflächenverschleiß V_{bmax} als Mittelwert aus je zwei Versuchen ermittelt. Die Ergebnisse der Versuche sind in der nachfolgenden Tabelle 2 angegeben.

| | |
|---|---|
| Werkstück: | C45-Stahl Nr, 1.0503, Festigkeit ca. 600 N/mm². |
| Zerspanbedingungen: | Zahnvorschub f_{Z} = 0,02 mm |
| | Schnittgeschwindigkeit v_{c} = 141 m/min |
| | Schnittbreite aₑ = 1,2 mm |
| | Schnitttiefe aₚ = 2,4 mm |
| | Kühlung mit KSS 5% |
| | (= Kühlschmierstoff Wasser-in-Öl-Emulsion mit 5% Öl) |

Die Bearbeitung wurde bei einem durchschnittlichen Freiflächenverschleiß von V_{b} > 0,2 mm oder einem maximalen Freiflächenverschleiß V_{bmax} > 0,25 mm abgebrochen und in den Ergebnissen dann mit (./.) gekennzeichnet.

**Tabelle 2**

| **Standweg / m** | **20** | **40** | **60** | **80** | **100** |
|---|---|---|---|---|---|
| V_{b} / mm Erfindung | 0,04 | 0,06 | 0,07 | 0,,07 | 0,07 |
| V_{b}max / mm Erfindung | 0,05 | 0,08 | 0,09 | 0,09 | 0,10 |
| V_{b} / mm Vergleich | 0,06 | ./. | ./. | ./. | ./. |
| V_{b}max / mm Vergleich | 0,11 | ./. | ./. | ./. | ./. |

### Beispiel 3 - Schaftwerkzeuge

Das in diesem Beispiel beschichtete Werkzeugsubstrat war das gleiche wie in Beispiel 1. Auf der Substratoberfläche wurde ebenfalls zunächst eine 0,2 µm dicke TiAlN-Zwischenlage durch Lichtbogenverdampfen von einem Ti-Al-Mischtarget (Ti:Al = 50:50) abgeschieden (Bias: 100 V, 4 Pa Stickstoff, 0,8 A/cm2 spezifischer Verdampferstrom, Abscheidetemperatur: 550 °C).

Im Unterschied zu Beispiel 1 erfolgte die Abscheidung der erfindungsgemäßen Verschleißschutzbeschichtung mit einer Gesamtschichtdicke von 2 µm von 2 Ti-Al-Mischtargets mit einem Verhältnis Ti:Al = 50:50 durch Lichtbogenverdampfen (2 A/cm2 spezifischer Verdampferstrom) und die Anhebung des Aluminiumgehaltes in den sich periodisch mit der TiAlN-Lage (A) abwechselnden TiAlN-Lage (B) durch Verwendung von 2 Al-Targets durch duales Magnetronsputtern (13 W/cm² spezifische Leistung) (Bias: 80 V, 1,5 Pa Stickstoff, Abscheidetemperatur: 550 °C). Auch in Beispiel 2 wurden periodisch abwechselnd 90 Ti_{x(A)}Al_{y(A)}N-Lagen (A) mit Ti:Al = 50:50 und 90 Ti_{x(B)}Al_{y(B)}N-Lagen (B) mit Ti:Al = 33:67 abgeschieden, wobei die TiAlN-Lagen (A) jeweils eine Dicke von etwa 15-19 nm und die TiAlN-Lagen (B) jeweils eine Dicke von etwa 3-6 nm hatten.

### Beispiel 4 - Wendeschneidplatten

In diesem Beispiel wurden Wendeschneidplatte mit quadratischer Grundform, P2808, aus 42CrMo4-Stahl mit einer Festigkeit von 880 N/mm² mit einer erfindungsgemäßen Beschichtung und einer Vergleichsbeschichtung nach dem Stand der Technik versehen und in die Beschichteten Werkzeuge in Zerspanversuchen verglichen.

Das Substrat wurde vor dem Beschichten zunächst durch Nassstrahlen mit Korund (wie oben beschrieben) einer Schneidkantenverrundung bis zu einem Radius von 30 µm unterzogen.

### Herstellung einer erfindungsgemäßen Beschichtung

Auf der Substratoberfläche wurde zunächst eine 0,2 µm dicke TiAlN-Zwischenlage durch Lichtbogenverdampfen von einem Ti-Al-Mischtarget (Ti:Al = 50:50) abgeschieden (Bias: 100 V, 4 Pa Stickstoff, 1,0 A/cm² spezifischer Verdampferstrom, Abscheidetemperatur: 550 °C). Darüber wurde ebenfalls durch Lichtbogenverdampfen eine erfindungsgemäße Verschleißschutzbeschichtung mit einer Gesamtschichtdicke von 2 µm abgeschieden. Die Abscheidung erfolgte simultan von 4 Ti-Al-Mischtargets mit einem Verhältnis Ti:Al = 50:50 und 2 Ti-Al-Mischtargets mit einem Verhältnis Ti:Al = 33:67. (Bias: 60 V, 4,5 Pa Stickstoff, 1,0 A/cm² spezifischer Verdampferstrom bei beiden Targetsorten, Abscheidetemperatur: 550 °C). Das Substrat wurde auf einem Drehteller an den verschiedenen Targetsorten vorbeigeführt. Insgesamt wurden periodisch abwechselnd 90 Ti_{x(A)}Al_{y(A)}N-Lagen (A) mit Ti:Al = 50:50 und 90 Ti_{x(B)}Al_{y(B)}N-Lagen (B) mit Ti:Al = 33:67 abgeschieden, wobei die Ti_{x(A)}Al_{y(A)}N-Lagen (A) jeweils eine Dicke von etwa 15-19 nm und die Ti_{x(B)}Al_{y(B)}N-Lagen (B) jeweils eine Dicke von etwa 3-6 nm hatten. Anschließend wurde ebenfalls durch Lichtbogenverdampfen eine abschließende äußerste Lage von einem Ti-Al-Mischtarget mit einem Verhältnis Ti:Al = 33:67 mit einer Schichtdicke von 0,1 µm abgeschieden. (Bias: 40 V, 3,0 Pa Stickstoff, 0,8 A/cm² spezifischer Verdampferstrom, Abscheidetemperatur: 550 °C).

### Herstellung einer Vergleichsbeschichtung

Auf der Substratoberfläche wurde eine mehrlagige (60 Lagen) TiAlN-Verschleißschutzbeschichtung mit einer Gesamtschichtdicke von 4,0 µm von Ti-Al-Mischtargets mit einem Verhältnis Ti:Al = 33:67 durch Lichtbogenverdampfen abgeschieden (Abscheidetemperatur: 450 °C, 0,8 A/cm² spezifischer Verdampferstrom). Druck und Bias wurden variiert von 30 V und 5 Pa Stickstoff bis 60 V und 2 Pa Stickstoff. Anschließend wurde eine 0,1µm dicke TiN-Dekorlage von Ti-Targets mit 0,8 Pa Stickstoff, 0,8 A/cm² spezifischem Verdampferstrom und einem Bias von 100 V abgeschieden.

### Zerspanversuche 3

Die beschichteten Werkzeuge wurden in Fräsversuchen verglichen und der maximale Freiflächenverschleiß V_{bmax} als Mittelwert aus je zwei Versuchen ermittelt. Die Ergebnisse der Versuche sind in der nachfolgenden Tabelle 3 angegeben.

| | |
|---|---|
| Werkstück: | 42CrMo4-Stahl Nr, 1.7225, vergütet auf ca. 850 N/mm². |
| Zerspanbedingungen: | Vorschub v_{f} = 120 mm/min, |
| | Zahnvorschub f_{Z} = 0,2 mm |
| | Schnittgeschwindigkeit v_{c} = 235 m/min |
| | Fräsweg 6 x 800 mm |
| | Fräsen ohne Kühlung |

**Tabelle 3**

| **Standweg / mm** | **800** | **1600** | **2400** | **3200** | **4000** | **4800** |
|---|---|---|---|---|---|---|
| V_{b}max / mm Erfindung | 0,02 | 0,03 | 0,05 | 0,08 | 0,08 | 0,09 |
| V_{b}max / mm Vergleich | 0,04 | 0,08 | 0,12 | 0,12 | 0,14 | 0,17 |

## Patentansprüche

1. Werkzeug mit einem Grundkörper aus Hartmetall, Cermet, Keramik, Stahl oder Schnellarbeitsstahl und einer darauf im PVD-Verfahren aufgebrachten ein- oder mehrschichtigen Verschleißschutzbeschichtung, wobei wenigstens eine Schicht der Verschleißschutzbeschichtung eine Titan-Aluminium-Nitrid-Schicht, TiₓAl_{y}N mit x + y = 1 ist, welche verfahrensbedingt bis zu 5 Gew.-% weitere Metalle enthalten kann,
**dadurch gekennzeichnet, dass**
die TiₓAl_{y}N-Schicht eine mehrlagige Unterstruktur mit wenigstens 40 sich periodisch abwechselnder Ti_{x(A)}Al_{y(A)}N-Lagen (A) mit x(A) + y(A) = 1 und Ti_{x(B)}Al_{y(B)}N-Lagen (B) mit x(B) + y(B) = 1 aufweist,
wobei die Al-Konzentration y(B) in den Lagen (B) höchstens 70 At.-% beträgt (y(B) ≤ 0,70) und
die Al-Konzentration y(B) in den Lagen (B) 10 bis 25 At.-% höher ist als die Al-Konzentration y(A) in den Lagen (A) (y(B) = (y(A) + 0,10) bis (y(A) + 0,25)) und
die Ti_{x(A)}Al_{y(A)}N-Lagen (A) eine Dicke im Bereich von 2 bis 40 nm und die Ti_{x(B)}Al_{y(B)}N-Lagen (B) eine Dicke im Bereich von 1 bis 20 nm aufweisen und
die Ti_{x(A)}Al_{y(A)}N-Lagen (A) eine größere Dicke aufweisen als die Ti_{x(B)}Al_{y(B)}N-Lagen (B), wobei die TiₓAl_{y}N-Schicht eine Vickers-Härte Hv von 2500 bis 4000, eine mittlere Oberflächenrauheit Ra, gemessen über eine Länge von 10 µm, von ≤ 1,0 µm und einen Elastizitätsmodul (E-Modul) von 380 GPa bis 470 GPa aufweist.

2. Werkzeug nach einem der vorausgehenden Ansprüche, **dadurch gekennzeichnet, dass** die wenigstens eine TiₓAl_{y}N-Schicht in der Verschleißschutzbeschichtung höchstens 300 sich periodisch abwechselnde Ti_{x(A)}Al_{y(A)}N-Lagen (A) und Ti_{x(B)}Al_{y(B)}N-Lagen (B) aufweist.

3. Werkzeug nach einem der vorausgehenden Ansprüche, **dadurch gekennzeichnet, dass** die Ti_{x(A)}Al_{y(A)}N-Lagen (A) eine Dicke im Bereich von 4 bis 15 nm und die Ti_{x(B)}Al_{y(B)}N-Lagen (B) eine Dicke im Bereich von 2 bis 7 nm aufweisen.

4. Werkzeug nach einem der vorausgehenden Ansprüche, **dadurch gekennzeichnet, dass** die Ti_{x(A)}Al_{y(A)}N-Lagen (A) die 1,5- bis 3,0-fache Dicke der Ti_{x(B)}Al_{y(B)}N-Lagen (B) aufweisen.

5. Werkzeug nach einem der vorausgehenden Ansprüche, **dadurch gekennzeichnet, dass** das Konzentrationsverhältnis von Ti zu Al in den Ti_{x(A)}Al_{y(A)}N-Lagen (A) x(A) : y(A) = 0,40 : 0,60 bis 0,60 : 0,40 beträgt, vorzugsweise x(A) : y(A) = 0,45 : 0,55 bis 0,55 : 0,45, besonders bevorzugt x(A) : y(A) etwa 0,50 : 0,50.

6. Werkzeug nach einem der vorausgehenden Ansprüche, **dadurch gekennzeichnet, dass** die TiₓAl_{y}N-Schicht mit mehrlagiger Unterstruktur die äußerste Schicht der Verschleißschutzbeschichtung ist und optional wenigstens bereichsweise eine darüber angeordnete dünne Verschleißerkennungsschicht, vorzugsweise eine TiN- oder ZrN-Schicht, mit einer Dicke von 0,1 bis 1,5 µm aufweist.

7. Werkzeug nach einem der vorausgehenden Ansprüche, **dadurch gekennzeichnet, dass** die TiₓAl_{y}N-Schicht eine Vickers-Härte Hv von 3000 bis 3500 aufweist.

8. Werkzeug nach einem der vorausgehenden Ansprüche, **dadurch gekennzeichnet, dass** die TiₓAl_{y}N-Schicht eine mittlere Oberflächenrauheit Ra, gemessen über eine Länge von 10 µm, von ≤ 0,5 µm aufweist.

9. Werkzeug nach einem der vorausgehenden Ansprüche, **dadurch gekennzeichnet, dass** die TiₓAl_{y}N-Schicht einen Elastizitätsmodul (E-Modul) von 420 GPa bis 460 GPa aufweist.

10. Werkzeug nach einem der vorausgehenden Ansprüche, **dadurch gekennzeichnet, dass** es ein Vollhartmetallwerkzeug oder eine Wendeschneidplatte ist.

## Claims

1. Tool, comprising a base body made of hard metal, cermet, ceramics, steel or high-speed steel; and a single-layer or multi-layer anti-wear protective coating applied thereto in a PVD process, wherein at least one layer of said anti-wear protective coating is a titanium-aluminium-nitride layer, TiₓAl_{y}N where x + y = 1, which layer can contain, according to the process, up to 5 % by weight of further metals
**characterized in that**
the TiₓAl_{y}N layer has a multi-coat substructure comprising at least 40 periodically alternating Ti_{x(A)}Al_{y(A)}N coats (A) where x(A) + y(A) = 1 and Ti_{x(B)}Al_{y(B)}N coats (B) where x(B) + y(B) = 1,
wherein the Al concentration y(B) in coats (B) amounts at most to 70 at.% (y(B) ≤ 0.70) and
wherein the Al concentration y(B) in coats (B) is from 10 to 25 at.% higher than the Al concentration y(A) in coats (A) (y(B) = (y(A) + 0.10) to (y(A) + 0.25)) and
wherein the Ti_{x(A)}Al_{y(A)}N coats (A) have a thickness within the range of from 2 to 40 nm, and the Ti_{x(B)}Al_{y(B)}N coats (B) have a thickness within the range of from 1 to 20 nm, and wherein the Ti_{x(A)}Al_{y(A)}N layers (A) have a greater thickness than the Ti_{x(B)}Al_{y(B)}N layers (B),
wherein the TiₓAl_{y}N layer has a Vickers hardness HV of from 2500 to 4000, an average surface roughness Ra, measured over a length of 10 µm, of ≤ 1.0 µm and a modulus of elasticity (E-modulus) of 380 GPa to 470 GPa.

2. Tool according to one of the preceding claims, **characterized in that** the at least one TiₓAl_{y}N layer in the anti-wear protective coating has at most 300 periodically alternating Ti_{x(A)}Al_{y(A)}N coats (A) and Ti_{x(B)}Al_{y(B)}N coats (B).

3. Tool according to one of the preceding claims, **characterized in that** the Ti_{x(A)}Al_{y(A)}N coats (A) have a thickness within the range of from 4 to 15 nm and the Ti_{x(B)}Al_{y(B)}N coats (B) have a thickness within the range of from 2 to 7 nm.

4. Tool according to one of the preceding claims, **characterized in that** the Ti_{x(A)}Al_{y(A)}N coats (A) have 1.5 to 3.0 times the thickness of the Ti_{x(B)}Al_{y(B)}N coats (B).

5. Tool according to one of the preceding claims, **characterized in that** the concentration ratio of Ti to Al in the Ti_{x(A)}Al_{y(A)}N coats (A) x(A):y(A) is 0.40:0.60 to 0.60:0.40, preferably x(A):y(A) = 0.45:0.55 to 0.55:0.45, particularly preferably x(A):y(A) is approximately 0.50:0.50.

6. Tool according to one of the preceding claims, **characterized in that** the TiₓAl_{y}N layer with a multi-coat substructure is the outermost layer of the anti-wear protective coating and optionally has at least in certain regions a superimposed thin wear detection layer, preferably a TiN or ZrN layer, with a thickness of 0.1 to 1.5 µm.

7. Tool according to one of the preceding claims, **characterized in that** the TiₓAl_{y}N layer has a Vickers hardness HV of 3000 to 3500.

8. Tool according to one of the preceding claims, **characterized in that** the TiₓAl_{y}N layer has an average surface roughness Ra, measured over a length of 10 µm, of ≤ 0.5 µm.

9. Tool according to one of the preceding claims, **characterized in that** the TiₓAl_{y}N layer has a modulus of elasticity (E-modulus) of 420 GPa to 460 GPa.

10. Tool according to one of the preceding claims, **characterized in that** the tool is a solid hard metal tool or an indexable cutter insert.

## Revendications

1. Outil avec un corps de base en métal dur, en cermet, en céramique, en acier ou en acier à coupe rapide et avec un revêtement de protection contre l'usure en une ou plusieurs couches appliquées selon la technique PVD, une couche du revêtement de protection contre l'usure étant une couche de nitrure de titane-aluminium, TiₓAl_{y}N avec x + y = 1, qui est susceptible de contenir, pour des raisons de procédé, jusqu'à 5 % en poids d'autre métaux,
**caractérisé en ce que**
la couche de TiₓAl_{y}N comprend une sous-structure multicouches avec au moins quarante couches périodiquement alternantes (A) de Ti_{x(A)}Al_{y(A)}N avec x(A) + y(A) = 1 et (B) de Ti_{x(B)}Al_{y(B)}N avec x(B) + y(B)= 1,
la concentration en Al y(B) dans les couches (B) étant au maximum de 70 % atomiques (y(B) ≤ 0,70) et
la concentration en Al y(B) dans les couches (B) étant de 10 à 25 % atomiques supérieure à la concentration en Al y(A) dans les couches (A) (y(B) = (y(A) + 0,10) à (y(A) + 0,25)) et
les couches (A) de Ti_{x(A)}Al_{y(A)}N présentant une épaisseur de l'ordre de 2 à 40 nm et les couches (B) de Ti_{x(B)}Al_{y(B)}N présentant une épaisseur de l'ordre de 1 à 20 nm et
les couches (A) de Ti_{x(A)}Al_{y(A)}N présentant une épaisseur plus grande que les couches (B) de Ti_{x(B)}Al_{y(B)}N,
la couche de TiₓAl_{y}N ayant une dureté Vickers Hv de 2500 à 4000, une rugosité de surface moyenne Ra, mesurée sur une longueur de 10 µm, de ≤ 1,0 µm et un module d'élasticité (module E) de 380 GPa à 470 GPa.

2. Outil selon la revendication précédente, **caractérisé en ce que** ladite au moins une couche de TiₓAl_{y}N comprend, dans le revêtement de protection contre l'usure, au maximum trois cents couches périodiquement alternantes (A) de Ti_{x(A)}Al_{y(A)}N et (B) de Ti_{x(B)}Al_{y(B)}N.

3. Outil selon l'une des revendications précédentes, **caractérisé en ce que** les couches (A) de Ti_{x(A)}Al_{y(A)}N présentent une épaisseur de l'ordre de 4 à 15 nm et les couches (B) de Ti_{x(B)}Al_{y(B)}N présentent une épaisseur de l'ordre de 2 à 7 nm.

4. Outil selon l'une des revendications précédentes, **caractérisé en ce que** les couches (A) de Ti_{x(A)}Al_{y(A)}N présentent une épaisseur 1, 5 à 3,0 fois de celle des couches (B) de Ti_{x(B)}Al_{y(B)}N.

5. Outil selon l'une des revendications précédentes, **caractérisé en ce que** le rapport de concentration de Ti à Al dans les couches (A) de Ti_{x(A)}Al_{y(A)}N est x(A) : y(A) = 0,40 : 0,60 à 0,60 : 0,40, de préférence x(A) : y(A) = 0,45 : 0,55 à 0,55 : 0,45, de manière particulièrement préférée x(A) : y(A) environ 0,50 : 0,50.

6. Outil selon l'une des revendications précédentes, **caractérisé en ce que** la couche de TiₓAl_{y}N avec une sous-structure multicouche est la couche la plus à l'extérieur du revêtement de protection contre l'usure et qu'elle comprend, de manière optimale, au moins par zones, une couche superposée de reconnaissance d'usure, de préférence une couche de TiN ou de ZrN, ayant une épaisseur de 0,1 à 1,5 µm.

7. Outil selon l'une des revendications précédentes, **caractérisé en ce que** la couche de TiₓAl_{y}N présente une dureté Vickers Hv de 3000 à 3500.

8. Outil selon l'une des revendications précédentes, **caractérisé en ce que** la couche de TiₓAl_{y}N présente une rugosité de surface moyenne Ra, mesurée sur une longueur de 10 µm, de ≤ 0,5 µm.

9. Outil selon l'une des revendications précédentes, **caractérisé en ce que** la couche de TiₓAl_{y}N présente un module d'élasticité (module E) de 420 GPa à 460 GPa.

10. Outil selon l'une des revendications précédentes, **caractérisé en ce qu'**il est un outil entièrement en métal dur ou une plaquette de coupe réversible.
